# EUROPÄISCHE PATENTSCHRIFT

(11) **EP 0 399 060 B1**
(45) Veröffentlichungstag und Bekanntmachung des Hinweises auf die Patenterteilung: **24.05.1995**
(21) Anmeldenummer: 89109158.9
(22) Anmeldetag: 22.05.1989
(51) Int. Cl.: H01L 27/108, H01L 21/82

(54) **Halbleiterspeicheranordnung mit Kondensatoren mir zwei in einem Graben angeordneten Elektroden und Verfahren zu deren Herstellung**
Semiconductor memory arrangement using capacitors with two electrodes situated inside a groove, and method of producing the same
Dispositif de mémoire semi-conductrice comprenant des condensateurs avec deux électrodes disposées dans une tranchée et son procédé de fabrication

(43) Veröffentlichungstag der Anmeldung: 28.11.1990
(73) Patentinhaber: SIEMENS AKTIENGESELLSCHAFT, 80333 München (DE)
(72) Erfinder: Kellner, Walter-Ulrich, Dr. Dipl.-Phys., D-8015 Marktschwaben (DE); Küsters, Karl-Heinz, Dr. Dipl.-Phys., D-8000 München 83 (DE); Müller, Wolfgang, Dr. Dipl.-Ing., D-8011 Putzbrunn (DE); Stelz, Franz-Xaver, Dipl.-Phys., D-8060 Dachau (DE)

(56) Entgegenhaltungen:
- EP-A- 0 164 829
- EP-A- 0 180 026
- EP-A- 0 187 596
- EP-A- 0 287 056
- JP-A- 1 005 052
- US-A- 4 734 384
- US-A- 4 918 500
- PATENT ABSTRACTS OF JAPAN, vol. 10, no. 289 (E-442)[2345], 2 Oktober 1986 & JP-A-61 108 163
- Patent Abstracts of Japan, Band 11, Nr. 130, (E-502)[2577], 23.4.87 und JP-A-61 274 357, 4.12.86;

## Beschreibung

Die Erfindung betrifft eine Halbleiterspeicheranordnung in einem Halbleitersubstrat mit Wortleitungen, Bitleitungen und mit Speicherzellen jeweils bestehend aus einem Grabenkondensator und einem MOS-Auswahltransistor, und Verfahren zu deren Herstellung.

Halbleiterspeicher bestehen aus einer Anzahl von Speicherzellen in einem z.B. aus Silizium bestehenden Halbleitersubstrat, die sich jeweils aus einem Kondensator zur Speicherung der Information und einem Transistor zur Auswahl des bestimmten Kondensators zusammensetzen. Um eine geringe Zugriffszeit bei hohem Speicherangebot zu erreichen, muß die Integrationsdichte der Anordnung erhöht werden, d.h. der Platzbedarf einer Zelle muß bei konstanter Kapazität des Kondensators minimiert werden.

Zu diesem Zweck wird, wie z.B. aus EPA 01 08 390 bekannt, der Kondensator als Grabenkondensator im Substrat ausgebildet. Die eine Elektrode wird dabei vom Substrat, die andere von dem leitenden Material gebildet, mit dem der Graben (Trench) nach der Isolation der ersten Elektrode gefüllt wird. Der Abstand der Gräben kann dadurch verringert werden, daß diese überlappend zum Feldoxyd, das die Zellen untereinander isoliert und die Isolation zu weiter oben liegenden leitenden Schichten darstellt, in das Substrat geätzt werden. Dies ist in EPA 0 187 596 beschrieben, wobei die Grabenätzung den Randbereich des Feldoxydes entfernt.

Solche Grabenkondensatoren können jedoch nicht beliebig dicht in den dem Substrat angeordnet werden, da sonst Leckströme und damit Verlust der gespeicherten Informationen auftreten. Um diesen sogenannten "punch through" zu verhindern, wird zum Beispiel in EPA 0 176 254 der sogenannte "stacked trench capacitor (STT)" vorgeschlagen. Dafür wird die Innenwand des in das Substrat geätzten Grabens mit einem ersten Isolatorfilm ausgekleidet und beide Elektroden in Form von leitenden Schichten, getrennt durch einen zweiten Isolatorfilm als Dielektrikum, innerhalb des Grabens untergebracht. Eine Elektrode muß dann aus dem Graben herausgeführt und über ein Kontaktloch an ein leitendes Gebiet des Auswahltransistors angeschlossen werden. Dieser Anschluß über ein Kontaktloch parallel zur Substratoberfläche erfordert zwei Fototechniken und damit aufgrund von Justiergenauigkeiten einen minimalen Abstand zwischen Graben und Transistor, der eine weitere Erhöhung der Integrationsdichte behindert.

In Dokument US-A-4 918 500 und dem entsprechenden Dokument JP-A-1 005 052, das eine Speicherzelle des STT-Typs beschreibt, wird vorgeschlagen, die Speicherelektrode über einen Kontakt an der Seitenwand des Grabens, und zwar in der Nähe der Grabenoberkante, mit einem leitendem Gebiet des Auswahltransistors zu verbinden. Durch einen solchen Seitenwandkontakt wird der Platzbedarf verringert, allerdings ist der Graben nicht überlappend zum Feldoxid angeordnet. Die Speicherzellen sind in einer Matrix mit zweifacher Staffelung angeordnet.

Eine vierfach gestaffelte Matrix für Speicherzellen ist in JP-A-61 274 357 bzw. Patent Abstracts of Japan Bd 11, Nr. 130 (E-502) [2577], 23.04.87 offenbart. Dabei müssen jeweils zwei miteinander verbundene Gate-Elektroden über ein Kontaktloch an eine weiter oben liegende Wortleitung angeschlossen werden. Diese Wortleitung verläuft in Richtung der geometrischen Verbindungslinie zwischen Kondensator und zugehörigem Auswahltransistor (1. Richtung). Senkrecht dazu (2. Richtung) verläuft die Bitleitung. Diese Anordnung erfordert eine aufwendige Herstellung und ein kompliziertes Layout aufgrund der Strukturierung der Gate-Elektroden. Der Integrationsgrad ist vor allem durch die Kontaktlöcher zwischen Gate-Elektrode und Wortleitung, von denen jeweils eins für zwei Zellen notwendig ist, stark beschränkt. Darüber hinaus ist ein anderer Speicherzellen-Typ vorgesehen.

Aufgabe der Erfindung ist es daher, eine Halbleiterspeicheranordnung anzugeben, bei der die Integrationsdichte weiter erhöht werden kann und die eine hohe Zuverlässigkeit aufweist. Aufgabe der Erfindung ist es außerdem, Verfahren zur Herstellung einer solchen Halbleiterspeicheranordnung anzugeben, die einfach und gut reproduzierbar sind.

Diese Aufgabe wird bei einer Anordnung der eingangs genannten Art durch die Merkmale des Patentanspruchs 1 und der Patentansprüche 6 bis 8 gelöst. Weiterbildungen der Erfindung sind Gegenstand von Unteransprüchen.

In der EPA 0 177 066 ist zwar eine Speicherzelle mit einem seitlichen Anschluß durch eine Öffnung in der isolierenden Schicht an der Trenchinnenwand beschrieben. Dabei wird jedoch ausschließlich ein grundsätzlich anderer Zelltyp verwendet, bei dem die Isolation der einzelnen Zellen nicht durch die als LOCOS-Isolation bekannte Technik mit Hilfe von Feldoxyd, sondern durch einen Graben erfolgt; dieser Zelltyp wird als "Isolation Merged Vertical Cell (IVEC)" bezeichnet. Dabei liegen Auswahltransistor und Bitleitungskontakt jeder Zelle auf einer Siliziuminsel, die volständig von Trenchbahnen umgeben ist. Der Kondensator dieser Zelle besteht aus im Trench vergrabenen Elektroden, wobei jeder Trench zwei Kondensatoren aufnimmt, die in der Grabenmitte eine gemeinsame Elektrode besitzen. Bei diesem Zelltyp wird die Integrationsdichte dadurch beschränkt, daß auch der Bitleitungskontakt auf der Siliziuminsel untergebracht werden muß, und daher doppelt so viele Bitleitungskontakte benötigt werden, daher wird er für hochintegrierte Schaltungen wie zum Beispiel den 16 M-Speicher nicht eingesetzt. Darüberhinaus weist das in der EPA 0 177 066 vorgestellte Konzept weitere Schwierigkeiten auf:
1. In jedem Graben sind zwei Kondensatoren sehr dicht beieinander untergebracht. Für eine ausreichende Isolation ist eine Implantation des Grabenbodens notwendig. Die Herstellung der ersten Elektroden an den Grabeninnenwänden mittels des vorgeschlagenen Ätzprozesses erhöht die Gefahr eines Kurzschlusses zwischen Kondensatoren zweier verschiedener Zellen, da leicht Reste am Grabenboden zurückbleiben.
2. Für den Kontakt zwischen Kondensator und Transistor wird eine aufwendige Fototechnik mit zwei Lackschichten und einer Oxydschicht, eine sogenannte "Tri-level Technik" eingesetzt. Da an beiden gegenüberliegenden Seiten einer Trenchbahn die erste Isolierschicht geöffnet wird, ist eine genaue Justierung nötig.
3. Durch die Anordnung der Zellen mit durchgehenden Trenchbahnen besteht die Gefahr, daß die Auswahltransistoren vom Substrat abgekoppelt werden; diese Gefahr wächst mit zunehmender Integrationsdichte. An den Trenchseitenwänden werden parasitäre Kondensatoren gebildet.

Bei der erfindungsgemäßen Anordnung, die sich für eine hohe Integrationsdichte eignet, und den erfindungsgemäßen Verfahren treten diese Schwierigkeiten nicht auf:
1. Da jeder Graben nur einen Kondensator beherbergt, ist ein vollständiges Entfernen des Materials der ersten Elektrode am Grabenboden nicht notwendig. Der Implantationsschritt entfällt. Die zweite, als Dielektrikum zwischen den Elektroden wirkende Isolationsschicht bedeckt die gesamte erste Elektrode einschl. des Grabenbodens.
2. Für die Öffnung der ersten Isolationsschicht zur Herstellung des Trench-Kontaktes zum Transistor wird eine einfache Fototechnik eingesetzt. In einer besonderen Ausführungsform des des Verfahrens kann darüberhinaus auf eine Strukturierung der Fotolackschicht verzichtet werden oder sogar ein selbstjustierter Kontakt hergestellt werden,
3. Da der Grabenkondensator nur eine kleine Fläche einnimmt und den Auswahltransistor nicht umschließt, kann ein Abkoppeln des Transistors vom Substrat nicht eintreten.

Die Erfindung wird nachfolgend anhand der in den Zeichnungen dargestellten Ausführungsbeispiele näher beschrieben, wobei zur besseren Kenntlichmachung in den Figuren nur die wesentlichen Teile der Anordnung und des Verfahrens aufgeführt sind. Es zeigen
FIG 1 - 5 einen Querschnitt durch einen Grabenkondensator in schematischer Darstellung, an dem die Schritte einer Ausführungsform des Verfahrens verdeutlicht werden,
FIG 6 - 10 und
FIG 11 - 16 zwei weitere Ausführungsformen des Verfahrens anhand eines Querschnittes durch einen Grabenkondensator.

FIG 17 zeigt eine Aufsicht auf die Speichermatrix mit einer vorteilhaften geometrischen Anordnung der Speicherzellen. In allen Figuren sind gleiche Teile mit gleichen Bezugszeichen bezeichnet.

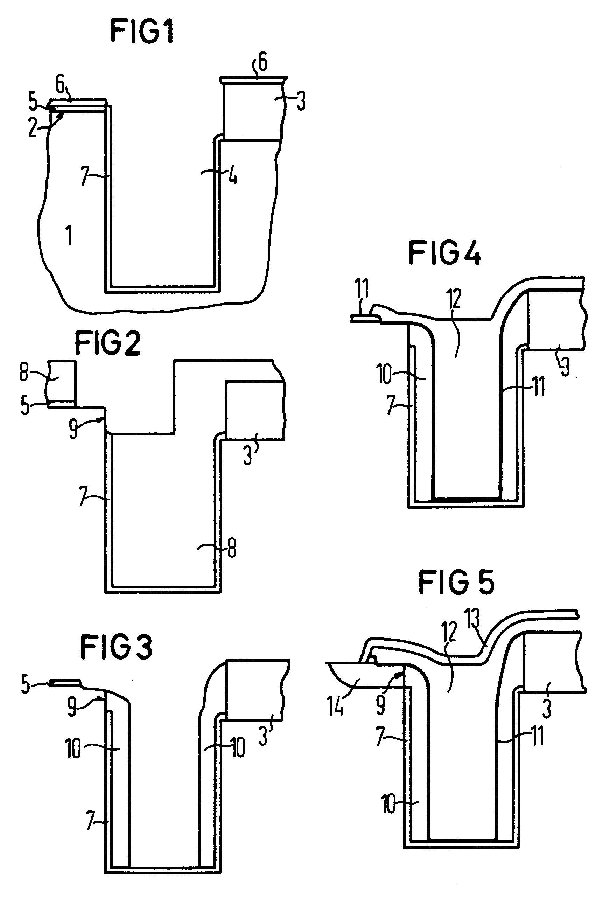

Gemäß FIG 1 ist die Oberfläche 2 eines Halbleitersubstrats 1, zum Beispiel eines Siliziumwafers, nach dem sogenannten LOCOS-Isolationsprozeß teilweise mit Feldoxyd 3 bedeckt. Anstatt durch Feldoxid kann die Isolation auch durch vergrabene Dickoxid-Gebiete (Buried Oxide, "BOX-Isolation") erfolgen. Überlappend zum Feldoxydbereich 3 wird ein Graben 4 zur Aufnahme des Speicherkondensators geätzt, wobei nach bekanntem Verfahren eine Maske mit den Schichten Siliziumoxyd 5/Siliziumnitrid 6/TEOS (nicht abgebildet) verwendet wird. Bei der Entfernung der TEOS-Schicht mittels Naßätzen wird auch das Feldoxyd 3 etwas angegriffen. Anschließend erfolgt Oxydation der Trenchinnenwand(4), so daß 10 - 150 nm Siliziumdioxyd 7 als erste isolierende Schicht gebildet werden; bevorzugt wird eine Dicke von 50nm.

Da dabei auch auf dem Nitrid 6 eine langsame Oxydation erfolgt, wird anschließend die dünne Nitridoxid-Schicht (NiOx, nicht dargestellt) entfernt, dann wird die Nitridmaske 6 mit H₃PO₄ gestrippt (FIG 2). Für die Öffnung des Innenwandoxyds 7 an der oberen Trenchkante wird eine einfache Fototechnik eingesetzt: Nach der Belackung (Fotolackschicht 8) wird der Wafer durch eine Maske mit einer bestimmten Belichtungsdosis und -dauer belichtet, so daß beim Entwickeln des Lacks 8 unbelichteter Lack am Trenchboden bleibt. Es kann nützlich sein, eine doppelte Belackung anzuwenden, bei der eventuell die erste Lackschicht ganzflächig zurückgeätzt wird. An der oberen Grabenkante wird zur Herstellung des Trenchkontakts 9 nun das Oxyd 5, 7 geätzt; dann wird die Lackmaske 8 entfernt.

Zur Erzeugung der ersten (äußeren) Elektrode 10 wird beispielsweise in einem CVD-Prozeß ein leitendes Material, z. B. polykristallines Silizium von ca. 100 - 150 nm Dicke abgeschieden (FIG 3). Die Dotierung des polykristallinen Siliziums (10) erfolgt entweder mit Hilfe einer Arsen-TEOS-Schicht (nicht dargestellt) nach bekannten Verfahren, die hinterher entfernt wird, oder gleichzeitig mit der Polysiliziumabscheidung durch Zusatz von Dotierstoffen. Nach einem anisotropen Rückätzprozeß unter Verwendung von Chlor oder Chlorverbindungen bleiben sogenannte Spacer stehen, waagerechte (d.h. zur Substratoberfläche parallele) Oberflächen sind frei von Polysilizium. Der Spacer 10 aus Polysilizium bildet den Anschluß zum Substrat am Grabenkontakt 9.

Figur 4 zeigt den Graben nach Herstellung des vollständigen Kondensators: auf der ersten Elektrode 10 ist ein Dielektrikum 11 abgeschieden, bekannterweise ist eine sogenannte ONO-3fach-Schicht vorteilhaft, die aus Polysiliziumoxyd/Siliziumnitrid/Nitridoxyd besteht, wobei die Komponenten Dicken von z.B. 3nm/8nm/2nm aufweisen. Die zweite Elektrode 12 füllt den Graben vollständig auf. Dazu wird n-dotiertes Polysilizium von ca. 300 nm Dicke abgeschieden, die Dotierung kann mit Hilfe einer TEOS-Schicht erfolgen. Der verbleibende Spalt wird mit undotiertem Polysilizium aufgefüllt, das dann bis zur Grabenoberkannte zurückgeätzt wird. Das dotierte Polysilizium wird mit einer Fototechnik strukturiert.

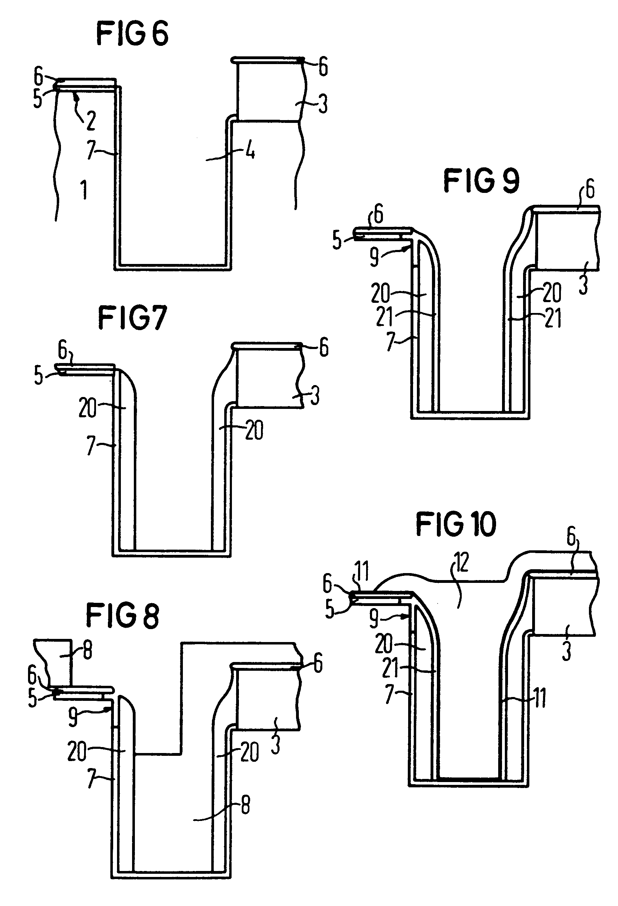

Das freiliegende Dielektrikum 11 außerhalb des Kondensators und das unterliegende Oxyd 5 werden geätzt (Figur 5). Wird nun die Oberfläche oxydiert, oxydieren die dotierten Gebiete schneller als das Substrat, so daß nach anschließendem Oxydätzen auf der zweiten Elektrode 12 eine Oxydschicht 13 zurückbleibt.

Anschließend wird der Auswahltransistor nach bekanntem Verfahren neben dem Kondensator hergestellt, so daß z.B. das Sourcegebiet 14 über den Trenchkontakt 9 mit der ersten Elektrode 10 verbunden ist. Die übrigen notwendigen Schritte werden mit bekannten Herstellungsverfahren ausgeführt, wobei die Wortleitungen und Bitleitungen derart erzeugt werden, daß die Bitleitungen im wesentlichen in einer ersten, durch die Verbindungslinie zwischen Kondensator und zugehörigem Auswahltransistor definierten Richtung verlaufen und die Wortleitungen im wesentlichen in einer dazu senkrechten zweiten Richtung verlaufen.

Als nichtdargestellte Variation des Prozeßablaufs kann die Nitridschicht 6 auch erst nach Ätzung des Polysiliziumspacers 10 im Trench bzw. nach Strukturierung der 2. Polysiliziumelektrode 12 entfernt werden. Dadurch wird sichergestellt, daß bei der Polysilizium-Spacerätzung das im planaren Bereich unter dem Grabenkontaktfenster liegende Substrat noch durch Oxyd 5/Nitrid 6 bedeckt ist und nicht durch die Spacerätzung angegriffen wird.

Die Figuren 6 bis 10 zeigen ein Verfahren zur Herstellung der erfindungsgemäßen Anordnung, das im wesentlichen mit dem ersten Verfahren übereinstimmt, so daß nur die Änderungen näher erläutert werden:

Vor der Fototechnik zur Erzeugung des Trenchkontakts wird bereits ein Polysiliziumspacer 20 an der Trenchseitenwand auf dem Seitenwandoxyd 7 erzeugt (FIG 7). Nach der Fototechnik und der Ätzung des Oxyds 5 und 7 an der oberen Grabenkante wird erneut Polysilizium 21 abgeschieden und rückgeätzt (FIG 9). Dabei wird der Spalt an der oberen Trenchkante, aus dem das Oxyd 5,7 herausgeätzt wurde, mit Polysilizium 21 gefüllt, so daß dort ein Kontakt gebildet wird. Die Dotierung des Polysiliziums kann bei der Erzeugung des ersten und/oder des zweiten Polyspacers erfolgen. Die Vorteile dieser Prozeßvariante sind:
a) die Tiefe des Trenchkontakts ist unabhängig von der unteren Lackkante im Trench, sie ist nur abhängig von der Oxydüberätzung ausgehend von der Oberkante des ersten Polysiliziumspacers 20 und von der Lage dieser Spaceroberkante. Die Herstellung von sehr flachen Grabenkontakten wird damit möglich.
b) Bei der Ätzung des Trenchseitenwandoxyds ist die Feldoxydkante durch den ersten Polysiliziumspacer 20 seitlich bedeckt und damit gegen die seitliche Oxydätzung geschützt. In FIG 8 ist die Verwendung einer Fototechnik gezeigt, jedoch ist die Herstellung eines Grabenkontakts, der selbstjustiert zum aktiven Gebiet ist, (d. h. keine Fototechnik benötigt) auch möglich.
c) Wenn die Dotierung der ersten Elektrode bei der ersten Polysiliziumabscheidung 20 erfolgt, kann die zweite Polysiliziumlage 21 undotiert/amorph abgeschieden werden. Die zweite Polysiliziumlage wird erst bei Fortführung des Prozesses durch Ausdiffussion aus der ersten Lage dotiert. Dies kann für die Erzeugung eines sehr dünnen/zuverlässigen Kondensator - Dielektrikums vorteilhaft sein. Die Rauhigkeit der zweiten Polysiliziumlage kann bei einer derartigen Prozeßführung geringer sein.

Die beiden erstgenannten Vorteile können auch erzielt werden, wenn der erste Spacer 20 aus Nitrid statt aus Polysilizium besteht.

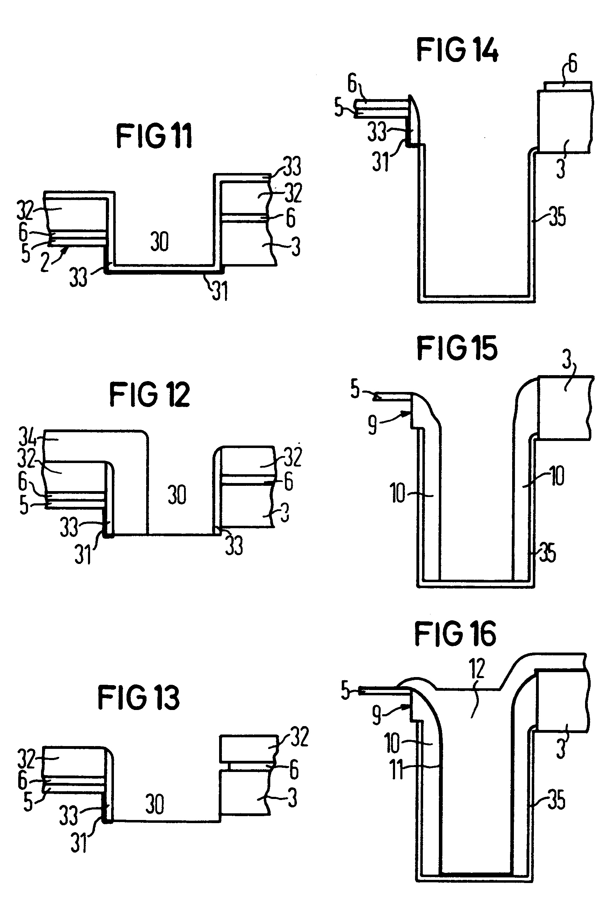

Die FIG 11 - 16 zeigen ein weiteres Verfahren, das zwei Trenchätzungen vorsieht; durch die Tiefe des zuerst erzeugten Grabens wird die Tiefe des Kontaktes bestimmt. Der erste Graben 30 wird nach bekanntem Verfahren ca. 200 - 400 nm tief in das Substrat geätzt und ca. 20 nm dick oxydiert (Oxidschicht 31).

Die Trenchmaske, bestehend aus Siliziumoxid 5/Silizium 6/TEOS 32 wird zunächst nicht entfernt; darüber wird ca. 30 nm Siliziumnitrid 33 abgeschieden (FIG 11). In FIG 12 ist das Nitrid bis auf Spacer an den senkrechten Innenwänden des Grabens zurückgeätzt. Durch einen weiteren Oxydationsprozeß bilden sich NiOx bzw. Siliziumoxyd an allen Oberflächen (nicht dargestellt). Eine Lackmaske 34 wird aufgebracht, die die Seite des Grabens, an der sich Feldoxyd 3 befindet, dem anschließenden Nitridätzprozeß aussetzt. Dafür kann eine isotrope sogenannte "down stream"- Ätzung angewandt werden, die eine hohe Selektivität zu Oxyd aufweist; eventuell ist es nötig, vorher NiOx zu entfernen (FIG 13). Die Lackmaske 34 und die darunter vorhandene dünne Oxydschicht 31 auf dem Grabenboden werden entfernt.

Anschließend wird der Graben auf die Tiefe des späteren Kondensators geätzt mit der noch vorhandenen Trenchmaske 5, 6, 32 (FIG 14). Diese Ätzung entfernt auch Teile des Nitridspacers 33. Die restliche TEOS-Schicht 32 der Trenchmaske wird weggeätzt. An der Grabeninnenwand wird die erste isolierende Schicht 35 gebildet, z. B. 120 nm Siliziumoxyd.

Mit einer kurzen Oxydätze wird der eventuell vorhandene dünne NiOx-Film auf dem Nitridspacer 33 entfernt, so daß anschließend das restliche Nitrid 33 an der oberen Grabenkante gestrippt werden kann. Der dafür eingesetzte Prozeß muß eine gute Selektivität zu Oxyd aufweisen, z. B. eignet sich Naßätzen mit H₃PO₄. Das unter dem Nitridspacer 33 vorhandene dünne Oxyd 31 wird naß gestrippt. An dieser Stelle an der oberen Grabenkante befindet sich nun eine Öffnung in der Isolationsschicht 35, die den Kontakt 9 zum späteren Transistor ermöglicht. Das Bilden der ersten Elektrode 10 des Kondensators und der weitere Prozeßverlauf erfolgt analog dem bisher beschriebenen Verfahren (Figur 16), die Wort- und Bitleitungen werden ebenfalls wie im ersten Beispiel erläutert hergestellt.

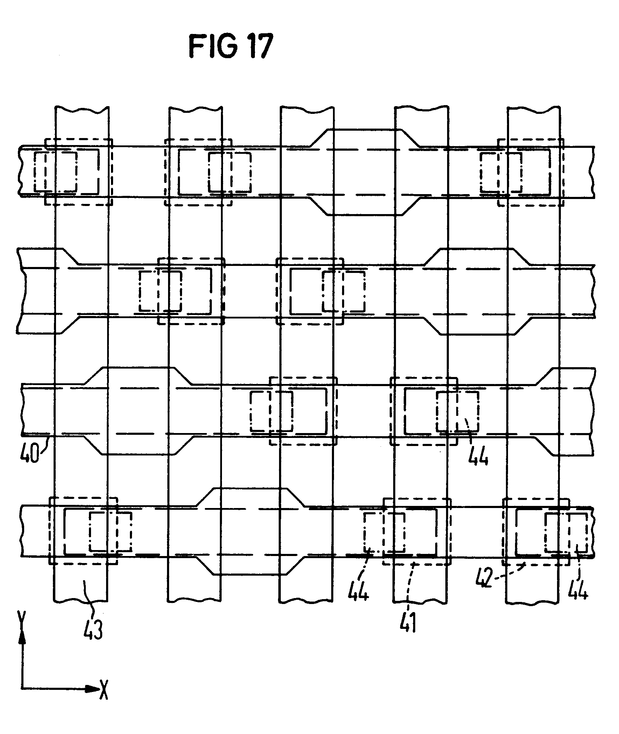

In Figur 17 ist ein Ausführungsbeispiel der erfindungsgemäßen geometrischen Anordnung der Zellen in einer Speichermatrix als Aufsicht auf die Oberfläche schematisch dargestellt. In einer ersten Richtung, die parallel zur Verbindungslinie zwischen Grabenkondensator und zugehörigem Auswahltransistor verläuft (d.h. parallel zu den Bitleitungen 40 und mit X bezeichnet), sind zwei aufeinanderfolgende Zellen spiegelsymmetrisch angeordnet: die Kondensatoren 41, 42 bzw. die Transistoren zweier Zellen liegen jeweils nebeneinander. in der 2., dazu senkrechten Richtung (d.h. parallel zu den Wortleitungen 43 und mit Y bezeichnet) ist die Lage der Zellen versetzt, und zwar pro Bitleitung um eine halbe Ausdehnung einer Zelle. Dadurch wird ein Raster von vier Bitleitungen gebildet, nach dem sich die Anordnung wiederholt.

Durch die Kombination von spiegelsymmetrischer Anordnung in der 1. und Versetzung der Zellen in der 2. Richtung wird ein möglichst großer Abstand zwischen Grabenkontakten 44 (entspricht dem Bereich 9 in den vorangegangenen Figuren) erreicht und die Zuverlässigkeit des Speichers erhöht.

## Patentansprüche

1. Halbleiterspeicheranordnung in einem Halbleitersubstrat (1) mit Wortleitungen (43), Bitleitungen (40) und mit Speicherzellen jeweils bestehend aus einem Grabenkondensator und einem MOS-Auswahltransistor mit
- einem Graben (4), der überlappend zu einem isolierenden Feldoxid (3) oder vergrabenen Isolationsoxid angeordnet ist, wobei der Transistor außerhalb des Grabenkondensators angeordnet ist,
- einer ersten isolierenden Schicht (7, 35), die die innere Oberfläche des Grabens bedeckt,
- einer ersten Elektrode (10, 20, 21) des Kondensators, die senkrecht zur Substratoberfläche in dem Graben auf der ersten isolierenden Schicht ausgebildet ist, und vollständig innerhalb des Grabens (4) liegt,
- einer zweiten isolierenden Schicht (11) auf der ersten Elektrode,
- einer zweiten Elektrode (12) des Kondensators, die senkrecht in dem Graben auf der zweiten isolierenden Schicht ausgebildet ist,
- einem Kontakt (9) zwischen der ersten Elektrode (10) des Kondensators und einem leitenden Gebiet (14) des Transistors, der seitlich durch eine Öffnung in der ersten isolierenden Schicht (7) nur an einer Stelle an der Oberkante der Grabeninnenwand erfolgt,
wobei die Speicherzellen folgendermaßen angeordnet sind:
- in einer ersten Richtung (X), die parallel zur Verbindungslinie zwischen Kondensator und zugehörigem Auswahltransistor verläuft, sind zwei aufeinanderfolgende Zellen spiegelsymmetrisch angeordnet, wobei die Symmetrieachse senkrecht zur ersten Richtung (X) durch den Mittelpunkt dieser zwei Zellen verläuft,
- in einer zweiten, zur ersten senkrechten Richtung (Y) sind die Zellen jeweils um eine halbe Zellenausdehnung versetzt,
- die Bitleitungen verlaufen im wesentlichen in der ersten Richtung und die Wortleitungen verlaufen im wesentlichen in der zweiten Richtung.

2. Anordnung nach Anspruch 1, **dadurch gekenn****zeichnet**, daß die erste isolierende Schicht (7,35) aus Siliziumoxyd oder Siliziumnitrid besteht.

3. Anordnung nach einem der Ansprüche 1 bis 2, **dadurch gekennzeichnet**, daß die zweite isolierende Schicht (11) ein dreilagiges ONO-Dielektrikum ist.

4. Anordnung nach einem der Ansprüche 1 bis 3, **dadurch gekennzeichnet**, daß die Öffnung in der ersten isolierenden Schicht (7) sich an der oberen Kante des Grabens (4) befindet und mit einem Teil des Materials der ersten Elektrode (10, 21) gefüllt ist.

5. Anordnung nach einem der Ansprüche 1 bis 4, **dadurch** gekennzeichnet, daß die zweite Elektrode (12) den Graben (4) vollständig auffüllt.

6. Verfahren zur Herstellung einer Halbleiterspeicheranordnung nach einem der Ansprüche 1 bis 5 mit folgenden Schritten:
- Ausbilden eines Grabens (4) in einem Halbleitersubstrat (1) überlappend zu einem Isolationsgebiet (3) zur Aufnahme eines Speicherkondensators;
- Herstellen einer ersten isolierenden Schicht (7) auf der Grabeninnenwand;
- Öffnen der ersten isolierenden Schicht nur an einer Stelle an der oberen Kante der Grabenwand zur Erzeugung eines Kontaktes (9) zum Substrat;
- Abscheiden und anisotropes Rückätzen einer ersten leitenden Schicht zur Bildung einer ersten Elektrode (10) des Kondensators;
- Abscheiden einer zweiten isolierenden Schicht (11) als Dielektrikum des Kondensators;
- Abscheiden einer zweiten leitenden Schicht, die den Graben auffüllt, und Strukturieren dieser Schicht zur Bildung der zweiten Elektrode (12);
- Erzeugen eines Auswahltransistors in der Nähe des Grabens (4) derart, daß ein leitendes Gebiet (14) des Transistors durch die Öffnung in der ersten isolierenden Schicht (7) im elektrischen Kontakt mit der ersten Elektrode (10) steht;
- Erzeugen von Wortleitungen und Bitleitungen derart, daß die Bitleitungen im wesentlichen in einer ersten, durch die Verbindungslinie zwischen Kondensator und zugehörigem Auswahltransistor definierten Richtung verlaufen und die Wortleitungen im wesentlichen in einer dazu senkrechten zweiten Richtung verlaufen.

7. Verfahren zur Herstellung einer Halbleiterspeicheranordnung nach einem der Ansprüche 1 bis 5 mit folgenden Schritten:
- Ausbilden eines Grabens (4) in einem Halbleitersubstrat (1) überlappend zu einem Isolationsgebiet (3) bis zur Tiefe eines späteren Kondensators unter Verwendung einer Dreifachschicht als Grabenmaske (5, 6);
- Entfernen der obersten Teilschicht der Grabenmaske;
- Herstellen einer ersten isolierenden Schicht (7) auf der Grabeninnenwand;
- Abscheiden einer leitenden oder isolierenden Schicht (20) und anisotropes Rückätzen, so daß nur an den Grabenwänden Spacer (20) verbleiben;
- Entfernen der ersten isolierenden Schicht (7) und der untersten Teilschicht (5) der Grabenmaske nur an einer Stelle der oberen Kante der Grabenwand durch Unterätzen des Spacers (20) und der mittleren Teilschicht (6) der Grabenmaske zur Erzeugung einer Öffnung zum Substrat;
- Abscheiden einer ersten leitenden Schicht (21) zur Kontaktierung des Substrats, durch die Öffnung und Bildung einer ersten Elektrode des Kondensators durch anisotropes Rückätzen;
- Abscheiden einer zweiten isolierenden Schicht (11) als Dielektrikum des Kondensators;
- Abscheiden einer zweiten leitenden Schicht, die den Graben auffüllt, und Strukturieren dieser Schicht zur Bildung einer zweiten Elektrode (12) des Kondensators;
- Erzeugen eines Auswahltransistors in der Nähe des Grabens (4) derart, daß ein leitendes Gebiet (14) des Transistors durch die Öffnung in der ersten isolierenden Schicht (7) in elektrischem Kontakt mit der ersten Elektrode steht;
- Erzeugung von Wortleitungen und Bitleitungen derart, daß die Bitleitungen im wesentlichen in einer ersten, durch die Verbindungslinie zwischen Kondensator und zugehörigem Auswahltransistor definierten Richtung verlaufen und die Wortleitungen im wesentlichen in einer dazu senkrechten zweiten Richtung verlaufen.

8. Verfahren zur Herstellung einer Halbleiterspeicheranordnung nach einem der Ansprüche 1 - 5 mit folgenden Schritten:
- Ausbilden eines Grabens (30) in einem Halbleitersubstrat (1) überlappend zu einem Isolationsgebiet bis zur Tiefe eines späteren Grabenkontakts (9)
- Aufbringen einer Schutzschicht (33) für den Grabenkontakt,
- Entfernen der Schutzschicht von Oberflächen parallel zur Substratoberfläche (2) und von einem Teil der Grabeninnenwand,
- Vertiefung des Grabens bis zur Gesamttiefe eines späteren Kondensators,
- Aufbringen einer ersten isolierenden Schicht (35) auf die Grabeninnenwand,
- Entfernen der restlichen Schutzschicht (33) an einer Stelle der oberen Grabenkante zur Erzeugung einer Öffnung des späteren Grabenkontaktes (9), wobei die übrige Grabenkante mit einer Lackmaske (34) abgedeckt ist,
- Abscheiden und anisotropes Rückätzen einer ersten leitenden Schicht zur Bildung einer ersten Elektrode (10) des Kondensators und Erzeugung des Grabenkontaktes (9),
- Abscheiden einer zweiten isolierenden Schicht (11) als Dielektrikum des Kondensators,
- Abscheiden einer zweiten leitenden Schicht, die den Graben auffüllt, und Strukturieren dieser Schicht zur Bildung einer zweiten Elektrode (12) des Kondensators,
- Erzeugung eines Auswahltransistors in der Nähe des Grabens (4) derart, daß ein leitendes Gebiet (14) des Transistors durch die Öffnung in der ersten isolierenden Schicht im elektrischen Kontakt mit der ersten Elektrode (10) steht,
- Erzeugung von Wortleitungen und Bitleitungen derart, daß die Bitleitungen im wesentlichen in einer ersten, durch die Verbindungslinie zwischen Kondensator und zugehörigem Auswahltransistor definierten Richtung verlaufen und die Wortleitungen im wesentlichen in einer dazu senkrechten zweiten Richtung verlaufen.

9. Verfahren nach einem der Ansprüche 6 bis 7,
**dadurch gekennzeichnet,** daß die erste isolierende Schicht (7) durch thermische Oxidation der Grabeninnenwand oder durch Abscheidung von Siliziumoxid gebildet wird.

10. Verfahren nach einem der Ansprüche 6 bis 7 und 9,
**dadurch gekennzeichnet**, daß zur Erzeugung des Grabenkontaktes (9) eine Fototechnik eingesetzt wird, bei der nach der Entwicklung die obere Grabenkante freiliegt und nicht-entwickelter Lack (8) am Grabenboden verbleibt.

11. Verfahren nach einem der Ansprüche 6, 9 und 10,
**dadurch gekennzeichnet,** daß die Grabenkontakttiefe durch die Belichtungsdosis oder die Belichtungsdauer eingestellt wird.

12. Verfahren nach einem der Ansprüche 6, 7, 9 bis 11,
**dadurch gekennzeichnet**, daß zur Erzeugung des Grabenkontaktes (9) eine Fototechnik eingesetzt wird, bei der zweimal Lack (8) aufgetragen wird und die zweite Lackschicht mit der Grabenkontaktmasse belichtet wird.

13. Verfahren nach Anspruch 12,
**dadurch gekennzeichnet**, daß die erste Lackschicht rückgeätzt oder derart belichtet wird, daß nach der Entwicklung unbelichteter Lack am Grabenboden bleibt und anschließend die zweite Lackschicht aufgebracht wird.

14. Verfahren nach einem der Ansprüche 6 bis 13,
**dadurch gekennzeichnet**, daß die Dotierung der ersten leitenden Schicht (10, 20, 21) mit Hilfe von Arsen-TEOS durchgeführt wird.

15. Verfahren nach einem der Ansprüche 6 bis 14,
**dadurch gekennzeichnet**, daß die anisotrope Rückätzung der ersten leitenden Schicht (10, 20, 21) mit Hilfe von reaktivem Ionenätzen durchgeführt wird.

16. Verfahren nach einem der Ansprüche 6 bis 15,
**dadurch gekennzeichnet**, daß als zweite isolierende Schicht (11) eine ONO-Dreifachschicht erzeugt wird.

17. Verfahren nach einem der Ansprüche 6 bis 16,
**dadurch gekennzeichnet**, daß die zweite isolierende Schicht (11) ganzflächig unter der zweiten Elektrode (12) verbleibt.

18. Verfahren nach einem der Ansprüche 7, 9 bis 17,
**dadurch gekennzeichnet**, daß als die leitende oder isolierende Schicht (20) polykristallines Silizium verwendet wird.

19. Verfahren nach Anspruch 18, **dadurch gekenn****zeichnet**, daß das polykristalline Silizium (20) dotiert wird und das die erste leitende Schicht bildende Polysilizium (21) undotiert abgeschieden wird und durch Ausdiffusion aus dem unterliegenden polykristallinen Silizium (20) dotiert wird.

20. Verfahren nach einem der Ansprüche 7, 9 - 17, **da****durch gekennzeichnet**, daß als die leitende oder isolierende Schicht (20) Siliziumnitrid verwendet wird.

21. Verfahren nach einem der Ansprüche 7, 9 - 20, **da****durch gekennzeichnet**, daß die Erzeugung des Grabenkontaktes (9) selbstjustiert in einem Ätzprozeß erfolgt, bei dem als Ätzmaske der Spacer (20) und Teile der Grabenmaske (6) eingesetzt werden.

22. Verfahren nach einem der Ansprüche 7, 9 - 21, **da****durcn gekennzeichnet**, daß die Öffnung der ersten isolierenden Schicht (7) mit einer Naßätzung erfolgt und die Tiefe des Grabenkontaktes (9) durch die Ätzzeit eingestellt wird.

23. Verfahren nach Anspruch 8, **dadurch gekennzeichnet,** daß die Schutzschicht (33) aus Siliziumnitrid gebildet wird.

24. Verfahren nach einem der Ansprüche 8, 23, **dadurch gekennzeichnet**, daß vor Aufbringen der Schutzschicht eine Oxydation (31) der Oberfläche durchgeführt wird.

25. Verfahren nach einem der Ansprüche 8, 23 - 24, **da****durch gekennzeichnet** , daß die Schutzschicht (33) von Oberflächen parallel zur Substratoberfläche (2) mittels eines anisotropen Rückätzprozesses entfernt wird und von Teilen der Grabeninnenwand durch einen isotropen Ätzprozeß unter Verwendung einer Fototechnik (34) entfernt wird.

26. Verfahren nach einem der Ansprüche 8, 23 - 25, **da****durch gekennzeichnet**, daß für die Vertiefung des Grabens Teile derselben Maske (5,6,32) wie für die Herstellung des Grabens (30) bis zur Tiefe des Grabenkontaktes (9) verwendet werden.

## Claims

1. Semiconductor memory arrangement in a semiconductor substrate (1) with word lines (43), bit lines (40) and with memory cells, each comprising a trench capacitor and a MOS selection transistor with
- a trench (4), which is arranged overlapping with an insulating field oxide (3) or buried insulating oxide, the transistor being arranged outside the trench capacitor,
- a first insulating layer (7, 35), which covers the inner surface of the trench,
- a first electrode (10, 20, 21) of the capacitor, which electrode is formed perpendicularly with respect to the substrate surface in the trench on the first insulating layer, and lies completely inside the trench (4),
- a second insulating layer (11) on the first electrode,
- a second electrode (12) of the capacitor, which electrode is formed perpendicularly in the trench on the second insulating layer,
- a contact (9) between the first electrode (10) of the capacitor and a conducting region (14) of the transistor, which contact takes place laterally through an opening in the first insulating layer (7) only at one location on the upper edge of the trench inner wall,
the memory cells being arranged as follows:
- in a first direction (X), which runs parallel to the connecting line between capacitor and associated selection transistor, two successive cells are arranged mirror-symmetrically, the axis of symmetry running perpendicularly with respect to the first direction (X) through the centre point of these two cells,
- in a second direction (Y), perpendicular to the first, the cells are respectively offset by half the extent of a cell,
- the bit lines run substantially in the first direction and the word lines run substantially in the second direction.

2. Arrangement according to Claim 1, characterized in that the first insulating layer (7, 35) comprises silicon oxide or silicon nitride.

3. Arrangement according to one of Claims 1 or 2, characterized in that the second insulating layer (11) is a three-layer ONO dielectric.

4. Arrangement according to one of Claims 1 to 3, characterized in that the opening in the first insulating layer (7) is located on the upper edge of the trench (4) and is filled with part of the material of the first electrode (10, 21).

5. Arrangement according to one of Claims 1 to 4, characterized in that the second electrode (12) completely fills the trench (4).

6. Method of producing a semiconductor memory arrangement according to one of Claims 1 to 5 with the following steps:
- forming a trench (4) in a semiconductor substrate (1), overlapping with an insulating region (3) for receiving a memory capacitor;
- producing a first insulating layer (7) on the trench inner wall;
- opening the first insulating layer only at one location on the upper edge of the trench wall for creating a contact (9) with the substrate;
- depositing and anisotropically etching back a first conducting layer for forming a first electrode (10) of the capacitor;
- depositing a second insulating layer (11) as a dielectric of the capacitor;
- depositing a second conducting layer, which fills the trench, and texturing this layer for forming the second electrode (12);
- producing a selection transistor in the vicinity of the trench (4) in such a way that a conducting region (14) of the transistor is in electrical contact with the first electrode (10) through the opening in the first insulating layer (7);
- producing word lines and bit lines in such a way that the bit lines run substantially in a first direction, defined by the connecting line between capacitor and associated selection transistor, and the word lines run substantially in a second direction, perpendicular thereto.

7. Method of producing a semiconductor memory arrangement according to one of Claims 1 to 5 with the following steps:
- forming a trench (4) in a semiconductor substrate (1), overlapping with an insulating region (3) down to the depth of a subsequent capacitor, using a triple layer as a trench mask (5, 6);
- removing the uppermost partial layer of the trench mask;
- producing a first insulating layer (7) on the trench inner wall;
- depositing a conducting or insulating layer (20) and anisotropic etching back, so that spacers (20) remain only on the trench walls;
- removing the first insulating layer (7) and the lowermost partial layer (5) of the trench mask only at one location of the upper edge of the trench wall by etching under the spacer (20) and the middle partial layer (6) of the trench mask for producing an opening with respect to the substrate;
- depositing a first conducting layer (21) for bonding the substrate through the opening and forming a first electrode of the capacitor by anisotropic etching back;
- depositing a second insulating layer (11) as a dielectric of the capacitor;
- depositing a second conducting layer, which fills the trench, and texturing this layer for forming a second electrode (12) of the capacitor;
- producing a selection transistor in the vicinity of the trench (4) in such a way that a conducting region (14) of the transistor is in electrical contact with the first electrode through the opening in the first insulating layer (7);
- producing word lines and bit lines in such a way that the bit lines run substantially in a first direction, defined by the connecting line between capacitor and associated selection transistor, and the word lines run substantially in a second direction, perpendicular thereto.

8. Method of producing a semiconductor memory arrangement according to one of Claims 1 - 5 with the following steps:
- forming a trench (30) in a semiconductor substrate (1), overlapping with an insulating region down to the depth of a subsequent trench contact (9)
- applying a protective layer (33) for the trench contact,
- removing the protective layer from surfaces parallel to the substrate surface (2) and from part of the trench inner wall;
- deepening the trench down to the total depth of a subsequent capacitor,
- applying a first insulating layer (35) to the trench inner wall,
- removing the remaining protective layer (33) at a location of the upper trench edge for producing an opening of the subsequent trench contact (9), the remaining trench edge being covered by a resist mask (34),
- depositing and anisotropically etching back a first conducting layer for forming a first electrode (10) of the capacitor and creating the trench contact (9),
- depositing a second insulating layer (11) as a dielectric of the capacitor,
- depositing a second conducting layer, which fills the trench, and texturing this layer for forming a second electrode (12) of the capacitor,
- producing a selection transistor in the vicinity of the trench (4) in such a way that a conducting region (14) of the transistor is in electrical contact with the first electrode (10) through the opening in the first insulating layer,
- producing word lines and bit lines in such a way that the bit lines run substantially in a first direction, defined by the connecting line between capacitor and associated selection transistor, and the word lines run substantially in a second direction, perpendicular thereto.

9. Method according to one of Claims 6 or 7, characterized in that the first insulating layer (7) is formed by thermal oxidation of the trench inner wall or by deposition of silicon oxide.

10. Method according to one of Claims 6 or 7 and 9, characterized in that, for creating the trench contact (9), use is made of a photographic technique in which, after development, the upper edge of the trench is bare and undeveloped resist (8) remains on the bottom of the trench.

11. Method according to one of Claims 6, 9 and 10, characterized in that the trench contact depth is set by the dose of exposure or the duration of exposure to light.

12. Method according to one of Claims 6, 7, 9 to 11, characterized in that, for creating the trench contact (9), use is made of a photographic technique in which resist (8) is applied twice and the second resist layer is exposed to light with the trench contact mask.

13. Method according to Claim 12, characterized in that the first resist layer is etched back or exposed to light in such a way that, after development, unexposed resist remains on the bottom of the trench and subsequently the second resist layer is applied.

14. Method according to one of Claims 6 to 13, characterized in that the doping of the first conducting layer (10, 20, 21) is carried out with the aid of arsenic-TEOS.

15. Method according to one of Claims 6 to 14, characterized in that the anisotropic etching back of the first conducting layer (10, 20, 21) is carried out with the aid of reactive ion etching.

16. Method according to one of Claims 6 to 15, characterized in that an ONO triple layer is produced as the second insulating layer (11).

17. Method according to one of Claims 6 to 16, characterized in that the second insulating layer (11) remains over its entire surface under the second electrode (12).

18. Method according to one of Claims 7, 9 to 17, characterized in that polycrystalline silicon is used as the conducting or insulating layer (20).

19. Method according to Claim 18, characterized in that the polycrystalline silicon (20) is doped and the polysilicon (21) forming the first conducting layer is deposited undoped, and is doped by diffusion out of the polycrystalline silicon (20) lying underneath.

20. Method according to one of Claims 7, 9 - 17, characterized in that silicon nitride is used as the conducting or insulating layer (20).

21. Method according to one of Claims 7, 9 - 20, characterized in that the creation of the trench contact (9) is performed in a self-adjusting manner in an etching process in which the spacer (20) and parts of the trench mask (6) are used as an etching mask.

22. Method according to one of Claims 7, 9 - 21, characterized in that the opening of the first insulating layer (7) is performed by a wet etching and the depth of the trench contact (9) is set by the etching time.

23. Method according to Claim 8, characterized in that the protective layer (33) is formed from silicon nitride.

24. Method according to one of Claims 8 or 23, characterized in that an oxidation (31) of the surface is carried out before applying the protective layer.

25. Method according to one of Claims 8, 23 - 24, characterized in that the protective layer (33) is removed from surfaces parallel to the substrate surface (2) by means of an anisotropic etching-back process and is removed from parts of the trench inner wall by an isotropic etching process using a photographic technique (34).

26. Method according to one of Claims 8, 23 - 25, characterized in that parts of the same mask (5, 6, 32) as for producing the trench (30) are used for deepening the trench down to the depth of the trench contact (9).

## Revendications

1. Dispositif de mémoire à semiconducteurs situé dans un substrat semiconducteur (1) comportant des lignes de transmission de mots (43), des lignes de transmission de bits (40) et des cellules de mémoire constituées chacune par un condensateur en sillon et un transistor de sélection MOS, comportant
- un sillon (4), qui est disposé en chevauchement sur un oxyde de champ isolant (3) ou sur un oxyde isolant enseveli, le transistor étant disposé à l'extérieur du condensateur en sillon,
- une première couche isolante (7,35), qui recouvre la surface intérieure du sillon,
- une première électrode (10,20,21) du condensateur, qui est disposée perpendiculairement à la surface du substrat dans le sillon situé dans la première couche isolante, et est située entièrement à l'intérieur du sillon (4),
- une seconde couche isolante (11) située sur la première électrode,
- une seconde électrode (12) du condensateur, qui est disposée verticalement dans le sillon sur la seconde couche isolante,
- un contact (9) situé entre la première électrode (10) du condensateur et une région conductrice (14) du transistor, et qui établi latéralement à travers une ouverture ménagée dans la première couche isolante (7), uniquement en un emplacement situé sur le bord supérieur de la paroi extérieure du sillon,
et dans lequel les cellules de mémoire sont disposées de la manière suivante :
- dans une première direction (X), qui est parallèle à la droite reliant le condensateur et le transistor de sélection associé, sont disposées symétriquement deux cellules successives, l'axe de symétrie étant perpendiculaire à la première direction (X) passant par le centre de ces deux cellules,
- dans une seconde direction (Y) perpendiculaire à la première, les cellules sont décalées respectivement de la moitié de l'étendue d'une cellule,
- les lignes de transmission de bits s'étendent essentiellement dans la première direction et les lignes de transmission de mots s'étendent essentiellement dans la seconde direction.

2. Dispositif suivant la revendication 1, caractérisé par le fait que la première couche isolante (7, 35) est formée par de l'oxyde de silicium ou du nitrure de silicium.

3. Dispositif suivant l'une des revendications 1 et 2, caractérisé par le fait que la seconde couche isolante (3) est un diélectrique ONO à trois couches.

4. Dispositif suivant l'une des revendications 1 à 3, caractérisé par le fait que l'ouverture ménagée dans la première couche isolante (7) est située au niveau du bord supérieur du sillon (4) et est remplie par une partie du matériau de la première électrode (10,21).

5. Dispositif suivant l'une des revendications 1 à 4, caractérisé par le fait que la seconde électrode (12) remplit complètement le sillon (4).

6. Procédé pour fabriquer un dispositif de mémoire à semiconducteurs suivant l'une des revendications 1 à 5, comportant les étapes suivantes :
- formation d'un sillon (4) dans un substrat semiconducteur (1) en chevauchement avec une région isolante (3) destinée à recevoir un condensateur de mémoire;
- fabrication d'une première couche isolante (7) sur la paroi intérieure du sillon;
- ouverture de la première couche isolante uniquement en un emplacement situé au niveau du bord supérieur de la paroi du sillon pour l'établissement d'un contact (9) de liaison avec le substrat,
- dépôt et rétrocorrosion anisotrope d'une première couche conductrice pour la formation d'une première électrode (10) du condensateur;
- dépôt d'une seconde couche isolante (11) en tant que diélectrique du condensateur;
- dépôt d'une seconde couche conductrice, qui remplit le sillon, et structuration de cette couche pour former la seconde électrode (12);
- production d'un transistor de sélection à proximité du sillon (4) de telle sorte qu'une région conductrice (14) du transistor établit, grâce à l'ouverture ménagée dans a première couche isolante (7), un contact électrique avec la première électrode (10);
- production de lignes de transmission de mots et de lignes de transmission de bits de telle sorte que les lignes de transmission de bits s'étendent essentiellement dans une première direction définie par la droite reliant le condensateur et le transistor de sélection associés, les lignes de transmission de mots s'étendent essentiellement dans une seconde direction perpendiculaire à la première.

7. Procédé pour fabriquer un dispositif de mémoire à semiconducteurs suivant l'une des revendications 1 à 5, comprenant les étapes suivantes :
- formation d'un sillon (4) dans un substrat semiconducteur (1) en chevauchement avec une région isolante (3) jusqu'à la profondeur d'un condensateur formé ultérieurement, moyennant l'utilisation d'une couche triple en tant que masque (5,6) pour le sillon;
- élimination de la couche partielle supérieure du masque pour le sillon;
- fabrication d'une première couche isolante (7) sur la paroi intérieure du sillon;
- dépôt d'une couche conductrice ou isolante (20) et rétrocorrosion anistrope de sorte que seuls des spacers (entretoises) (20) subsistent sur les parois du sillon;
- élimination de la première couche isolante (7) et de la couche partielle la plus basse (5) du masque pour le sillon uniquement en un emplacement du bord supérieur de la paroi du sillon par corrosion sous-jacente de l'entretoise (20) et de la couche partielle centrale (6) du masque pour le sillon, pour la formation d'une ouverture aboutissant au substrat;
- dépôt d'une première couche conductrice (21) pour l'établissement du contact avec le substrat à travers l'ouverture, et formation d'une première électrode du condensateur par rétrocorrosion anisotrope;
- dépôt d'une seconde couche isolante (11) en tant que diélectrique du condensateur;
- dépôt d'une seconde couche conductrice, qui remplit le sillon, et structuration de cette couche pour former une seconde électrode (12) du condensateur;
- production d'un transistor de sélection à proximité du sillon (4) de telle sorte qu'une région conductrice (14) du transistor est placée, à travers l'ouverture ménagée dans la première couche isolante (7), en contact électrique avec la première électrode;
- production de lignes de transmission de mots et de lignes de transmission de bits de telle sorte que les lignes de transmission de bits s'étendent essentiellement dans une première direction définie par la droite reliant le condensateur et le transistor de sélection associé, les lignes de transmission de mots s'étendent essentiellement dans une seconde direction perpendiculaire à la première.

8. Procédé pour fabriquer un dispositif de mémoire à semiconducteurs suivant l'une des revendications 1-5, comprenant les étapes suivantes :
- formation d'un sillon (30) dans un substrat semiconducteur (1) en chevauchement avec une région isolante jusqu'à la profondeur d'un contact (9) de sillon, formé ultérieurement,
- dépôt d'une couche de protection (33) pour le contact de sillon,
- élimination de la couche protectrice de la surface parallèlement à la surface (2) du substrat, et d'une partie de la paroi intérieure du sillon,
- approfondissement du sillon jusqu'à la profondeur totale d'un convertisseur formé ultérieurement,
- dépôt d'une première couche isolante (35) pour la paroi intérieure du sillon,
- élimination de la couche de protection restante en un emplacement du bord supérieur du sillon pour la production d'une ouverture du contact (9) de sillon, formé ultérieurement, le reste du bord du sillon étant recouvert par un masque de laque (34),
- dépôt et rétrocorrosion anisotrope d'une première couche conductrice pour la formation d'une première électrode (10) du condensateur et la production du contact de sillon (9),
- dépôt d'une seconde couche isolante (30) en tant que diélectrique du condensateur,
- dépôt d'une seconde couche conductrice, qui remplit le sillon, et structuration de cette couche pour la formation de la seconde électrode (12) du condensateur,
- production d'un transistor de sélection à proximité du sillon (4) de telle sorte qu'une région conductrice (14) du transistor est placée, à travers l'ouverture ménagée dans la première couche isolante, en contact électrique avec la première électrode (10);
- production de lignes de transmission de mots et de lignes de transmission de bits de telle sorte que les lignes de transmission de bits s'étendent essentiellement dans une première direction définie par la droite reliant le condensateur et le transistor de sélection associé, les lignes de transmission de mots s'étendent essentiellement dans une seconde direction perpendiculaire à la première.

9. Procédé suivant l'une des revendications 6 à 7, caractérisé par le fait que la première couche isolante (7) est formée par oxydation thermique de la paroi intérieure du sillon ou par dépôt d'oxyde de silicium.

10. Procédé suivant l'une des revendications 6 à 7 et 9, caractérisé par le fait que pour la production du contact de sillon (9) on utilise une technique photochimique, selon laquelle, après développement, le bord supérieur du sillon est mis à nu et de la laque (8) non développée subsiste dans le fond du sillon.

11. Procédé suivant l'une des revendications 6, 9 et 10, caractérisé par le fait qu'on règle la profondeur de contact du sillon au moyen la dose d'exposition ou de la durée d'exposition.

12. Procédé suivant l'une des revendications 6, 7, 9 à 11, caractérisé par le fait que pour la production du contact de sillon (9), on utilise une technique photochimique, lors de laquelle on dépose de la laque (8) pour la seconde fois et on expose la seconde couche de laque ainsi que la masse de contact de sillon.

13. Procédé suivant la revendication 12, caractérisé par le fait qu'on élimine par rétrocorrosion la première couche de laque ou qu'on l'expose de manière qu'après le développement, la laque non exposée subsiste dans le fond du sillon et qu'on dépose ensuite la seconde couche de laque.

14. Procédé suivant l'une des revendications 6 à 13, caractérisé par le fait que le dopage de la première couche conductrice (10,20,21) est exécuté à l'aide d'arsenic-TEOS.

15. Procédé suivant l'une des revendications 6 à 14, caractérisé par le fait que la rétrocorrosion anisotrope de la première couche conductrice (10,20,21) est réalisée à l'aide d'une corrosion ionique réactive.

16. Procédé suivant l'une des revendications 6 à 15, caractérisé par le fait qu'on forme comme seconde couche isolante (11) une couche triple ONO.

17. Procédé suivant l'une des revendications 6 à 16, caractérisé par le fait que la seconde couche isolante (11) subsiste sur l'ensemble de la surface au-dessous de la seconde électrode (12).

18. Procédé suivant l'une des revendications 7, 9 à 17, caractérisé par le fait qu'on utilise comme couche conductrice ou isolante (20), du silicium polycristallin.

19. Procédé suivant la revendication 18, caractérisé par le fait qu'on dope le silicium polycristallin (20) et qu'on dépose sans dopage le polysilicium (21) constituant la première couche conductrice, et qu'on la dope par diffusion à partir du silicium polycristallin sous-jacent (20).

20. Procédé suivant l'une des revendications 7, 9-17, caractérisé par le fait qu'on utilise comme couche conductrice ou isolante (20), du nitrure de silicium.

21. Procédé suivant l'une des revendications 7, 9-20, caractérisé par le fait que la production du contact de sillon (9) s'effectue d'une manière auto-alignée au cours d'un processus de corrosion, lors duquel on utilise, comme masque de corrosion, l'entretoise (20) et des parties du masque (6) pour le sillon.

22. Procédé suivant l'une des revendications 7, 9-21, caractérisé par le fait qu'on forme l'ouverture de la première couche isolante (7) au moyen d'une corrosion par voie humide et qu'on règle la profondeur du contact de sillon (9) à l'aide du temps de corrosion.

23. Procédé suivant la revendication 8, caractérisé par le fait qu'on forme la couche protectrice (33) en utilisant du nitrure de silicium.

24. Procédé suivant l'une des revendications 8, 23, caractérisé par le fait qu'avant le dépôt de la couche protectrice, on exécute une oxydation (31) de la surface.

25. Procédé suivant l'une des revendications 8, 23-24, caractérisé par le fait qu'on élimine la couche protectrice (33) de surfaces parallèles à la surface (22) du substrat, au moyen d'un processus de rétrocorrosion anisotrope et qu'on élimine des parties de la paroi intérieure du sillon au moyen d'un processus de corrosion isotrope, moyennant l'utilisation d'une technique photochimique (34).

26. Procédé suivant l'une des revendications 8, 23-25, caractérisé par le fait qu'on utilise, pour approfondir le sillon, des parties des mêmes masques (5,6,32) que ceux utilisés pour la fabrication du sillon (30), jusqu'à la profondeur du contact de sillon (9).
